(19) **Europäisches Patentamt**

**European Patent Office**

**Office européen des brevets**

(11) Veröffentlichungsnummer: **0 201 634**
**B1**

(12) # EUROPÄISCHE PATENTSCHRIFT

(45) Veröffentlichungstag der Patentschrift:
27.09.89

(21) Anmeldenummer: 85116354.3

(22) Anmeldetag: 20.12.85

(51) Int. Cl.⁴: **H 04 L 1/24**, G 06 F 7/58,
G 06 F 11/26

(54) **Digitaler Wortgenerator zur automatischen Erzeugung periodischer Dauerzeichen aus n-bit-Wörtern aller Wortgewichte und deren Permutationen.**

(30) Priorität: 16.04.85 DE 3513551

(43) Veröffentlichungstag der Anmeldung:
20.11.86 Patentblatt 86/47

(45) Bekanntmachung des Hinweises auf die Patenterteilung:
27.09.89 Patentblatt 89/39

(84) Benannte Vertragsstaaten:
FR GB IT SE

(56) Entgegenhaltungen:
DE-A- 2 537 167
DE-A- 2 643 836

HEWLETT-PACKARD JOURNAL, Band 27, nr. 7, März
1976, Seiten 18-23, Palo Alto, US; I.R. YOUNG et al.: "A
50-Mbit/s pattern generator and error detector for
evaluating digital communications system
performance"
ELECTRONICS, Band 44, Nr. 21, 11. Oktober 1971,
Seiten 82-86, New York, US; K.P. ROBY: "Digital data
links deserve a bit error rate detector"

(73) Patentinhaber: **Wandel & Goltermann GmbH & Co,**
**Postfach 45 Mühleweg 5, D-7412 Eningen u.A. (DE)**

(72) Erfinder: **Gelbrich, Hans-Joachim, Dipl.-Ing.,**
**Springerzeile 44, D-1000 Berlin 20 (DE)**
Erfinder: **Lehmann, Erwin, Dipl.-Ing.,**
**Offenbacherstrasse 22, D-1000 Berlin 33 (DE)**

(74) Vertreter: **Kucher, Hans, Postfach 45 Mühleweg 5,**
**D-7412 Eningen u.A. (DE)**

## Beschreibung

Die Erfindung betrifft einen digitalen Wortgenerator nach dem Gattungsbegriff des Patentanspruchs 1. Da bestimmte periodische Signale als Meldungen oder Kennzustände in Datenübertragungs- und Datenverarbeitungseinrichtungen benutzt werden, besteht das Bedürfnis, das Ansprechen der für diese Kennsignale vorgesehenen Auswertungsschaltungen zu prüfen, indem das passende Signal an einem sendeseitigen Wortgenerator eingestellt wird. Ein mit dem Sendesignal synchronisierter Empfänger erzeugt das gleiche Wort und vergleicht das lokal erzeugte mit dem über die Übertragungsstrecke empfangenen Wort. Auf diesem Prinzip beruhende Geräte sind bekannt.

Andererseits sind im Hinblick auf den empfängerseitigen Vergleich ähnlich aufgebaute Bitfehlermeßgeräte bekannt, die Quasizufallsfolgen (QZF) als Prüfsignal verwenden. Eine QZF der Länge $(2^r-1)$ bit enthält periodische Teilfolgen nur in sehr kurzen Ausschnitten von unter 2r bit Länge. Im praktischen Betrieb der zu überprüfenden Übertragungswege treten aber bei schwach belegten Multiplexsystemen unter Umständen längere periodische Folgen auf. Trotz entsprechender Gegenmaßnahmen (Verwürflung, Codierung, Überwachung der Periodizität) ergeben sich bei manchen Übertragungswegen Schwierigkeiten, wenn die Eingangssignale über längere Zeit periodisch sind. Deshalb ist in manchen bekannten Bitfehlermeßgeräten auch ein Generator für gesondert zu schaltende periodische Teilfolgen enthalten (z. B. Meßgerät PF4 der Firma Wandel und Goltermann).

Der Inhalt des n-bit-Wortes, das eine Periode des periodischen Signals darstellt, wird bei bekannten Wortgeneratoren und Bitfehlermeßgeräten zu Beginn der Messung eingestellt und gegebenenfalls elektronisch gespeichert. Das hat zwei Nachteile:

a) Bekannte Datenübertragungs- und Datenverarbeitungseinrichtungen benutzen bestimmte Signale als Meldungen oder Kennzustände. Nun kann zwar das Ansprechen dieser Schaltungen geprüft werden, wenn das passende periodische Signal eingestellt wird. Nicht erkannt wird aber ein unbeabsichtigtes, fehlerhaftes Ansprechen einer solchen Schaltung auf ein anderes periodisches Signal, weil die Vielfalt für eine handbediente Einstellung zu groß ist.

Sollen alle $2^n$ möglichen n-bit-Wörter geprüft werden, so ist das bereits bei n = 8 sehr zeitraubend, bei n = 16 praktisch nicht mehr durchführbar.

b) Das Meßergebnis hängt häufig nicht nur vom Eingangssignal sondern auch vom Anfangszustand des Meßobjektes ab. Übertragungssysteme sind vom Schaltungsaufbau her im allgemeinen nach Potenzen von 2 organisiert (Binärzähler, Multiplexer, Rahmenaufbau). Wenn daher ein periodisches Signal der Periodenlänge 8 bit oder 16 bit dauernd anliegt, tritt immer wieder der gleiche Anfangszustand ein. Selbst wenn das kritische der $2^n$ möglichen n-bit-Wörter zufällig eingestellt wurde, ergibt sich die gesuchte Fehlfunktion nur dann, wenn zufällig auch der passende Anfangszustand des Systemes vorlag. Damit ist es fast unmöglich, ein kritisches periodisches Signal durch systematische Messungen zu finden.

Die Aufgaben des Wortgenerators nach der Erfindung sind:

a) Es soll ein Testsignal erzeugt werden, das alle periodischen Signale einer bestimmten wählbaren Periodenlänge enthält.

b) Der Vergleichswortgenerator des Empfängers soll durch das Testsignal synchronisiert werden können.

c) Die Suche nach systematischen Fehlern, die bei der Übertragung periodischer Digitalsignale auftreten, soll erleichtert werden.

Der Lösung dieser Aufgabe gehen die folgenden zum Teil durch Tabellen erläuterten Überlegungen voraus:

Als Wortgenerator wäre im einfachsten Fall ein n-bit-Binärzähler verwendbar, dessen Inhalt – periodisch wiederholt – das n-Bit-Wort darstellt und der beim Umschalten auf den nächsten Signalinhalt um 1 aufwärts oder abwärts zählt. Dabei entstünden aber die gleichen periodischen Signale mehrfach, wie folgendes Beispiel für die Periodenlänge n = 4 zeigt: Tabelle 1

| Zählerstand | dezimal | 12 | 6 | 3 | 9 |
|---|---|---|---|---|---|
| | binär | 1100 | 0110 | 0011 | 1001 |

Bei periodischer Wiederholung des binären Zählerstandes entsteht in allen dargestellten Fällen die gleiche periodische Folge, nämlich ein Wechsel zwischen zwei Nullbits und zwei Einsbits. Der Grund dafür ist, daß die vier Binärzahlen bei zyklischer Vertauschung ihrer Ziffern ineinander übergehen. Ähnliche Zusammenhänge gelten für die anderen möglichen Stellungen des gedachten Binärzählers, und es ergibt sich für n = 4 folgendes Gesamtbild:

Tabelle 2

| Zählerstand | bin. | 1111 | 1110 | 1100 | 1010 | 1000 | 0000 |
|---|---|---|---|---|---|---|---|
| | dez. | 15 | 14 | 12 | 10 | 8 | 0 |
| enthalten | dez. | – | 7, 11, 13 | 6, 3, 9 | 5 | 4, 2, 1 | 0 |

Statt der $2^4$ = 16 möglichen 4-bit-Wörter werden also nur z = 6, nämlich die Wörter 15, 14, 12, 10, 8 und 0 gebraucht, um alle periodischen Signale der Wortlänge 4 bit darzustellen. Berechnungen für andere Wortlängen n führen auf folgende Zahlen z:

Tabelle 3

| n | 2 | 3 | 4 | 5 | 6 | 7 | 8 | 9 | 10 | 11 | 12 | 13 | 14 | 15 | 16 |
|---|---|---|---|---|---|---|---|---|----|----|----|----|----|----|----|
| z | 3 | 4 | 6 | 8 | 14 | 20 | 36 | 60 | 108 | 188 | 352 | 632 | 1182 | 2192 | 4116 |

In Erkenntnis dieser Gegebenheiten schlägt die Erfindung zur automatischen Erzeugung von periodischen Dauerzeichen aus n-bit-Wörtern aller Wortgewichte und deren Permutationen vor, daß von den $2^n$ Wortgewichten und Permutationen eines n-bit-Worts während eines Testsignalzyklus' nur n-bit-Wörter einer wesentlich kleineren Anzahl z nacheinander aus einem Festwertspeicher abgerufen werden und die übrigen $(2^n - z)$ Permutationen dadurch entstehen, daß sich an den periodischen Teil des Testzyklus' eine die Zykluslänge bestimmende Rahmenbitfolge anschließt, deren Länge mit n keinen gemeinsamen Teiler hat. Dadurch wird in jedem Testsignalzyklus bezogen auf ein festes n-bit-Raster eine andere zyklische Vertauschung der n Bits der z Wörter gesendet, bis nach n Testsignalzyklen alle n möglichen Bitpositionen im Raster vorgekommen sind. Das eigentliche periodische Dauersignal entsteht durch m-malige Wiederholung jedes einzelnen n-bit-Worts. Die Zahl m ist einstellbar, z.B. auf m = 60.

Im Wortgenerator ist demzufolge nach der Erfindung statt des n-bit-Binärzählers ein Festwertspeicher für die z n-bit-Wörter sowie ein etwas kleinerer Binärzähler zur Adressierung des Festwertspeichers eingesetzt. Nach dem heutigen Stand der Technik ist der Aufwand für den zusätzlichen Festwertspeicher nicht sehr groß, es ergeben sich aber folgende Vorteile gegenüber der einfachen Lösung mit einem n-bit-Binärzähler:

a) Die Länge des gesamten Signalzyklus wird fest um den Faktor n vermindert und damit die notwendige Meßdauer herabgesetzt. Bei n = 16 ergibt sich aus der vorstehenden Tabelle 3 eine Verkürzung des periodischen Teils des Signalzyklus um den Faktor $65536/4116 = 15,9 \approx n$.

b) Wenn ein bestimmtes periodisches Signal zu einer Reaktion des Meßobjektes (Mustererkennung, Bitfehler) führt, dann ist es im Signalzyklus nur einmal enthalten. Das erleichtert die Suche nach diesem Signal.

Es ist im Prinzip gleichgültig, welches von mehreren zyklisch vertauschten n-bit-Wörtern zur Darstellung des zugehörigen periodischen Signals im Festwertspeicher eingeschrieben ist. Zweckmäßig ist es aber, sich immer auf den kleinsten oder den größten Wert festzulegen. Wird jeweils der größte Wert abgespeichert, so hat jedes dieser n-bit-Wörter außer den beiden Dauerfolgen (0000 ...., 1111 ....) in der ersten Stelle eine 1 und in der letzten Stelle eine 0, weil andernfalls mindestens eine zyklische Vertauschung zu einem größeren Wert führen würde, was der Voraussetzung widerspricht. Für die Fälle n = 2 bis n = 6 zeigt das die nachfolgende Tabelle 4 der gespeicherten n-bit-Wörter:

Tabelle 4

| n<br>Nr. | 6 | 5 | 4 | 3 | 2 |
|---|---|---|---|---|---|
| 1 | 111111 | 11111 | 1111 | 111 | 11 |
| 2 | 111110 | 11110 | 1110 | 110 | 10 |
| 3 | 111100 | 11100 | 1100 | 100 | 00 |
| 4 | 111010 | 11010 | 1010 | 000 | |
| 5 | 111000 | 11000 | 1000 | | |
| 6 | 110110 | 10100 | 0000 | | |
| 7 | 110100 | 10000 | | | |
| 8 | 110010 | 00000 | | | |
| 9 | 110000 | | | | |
| 10 | 101010 | | | | |
| 11 | 101000 | | | | |
| 12 | 100100 | | | | |
| 13 | 100000 | | | | |
| 14 | 000000 | | | | |

Zweckmässig wird während eines Testsignalzyklus jedes aus dem Festwertspeicher ausgelesene n-bit-Wort, über einen Schalter und einen Binärzähler gesteuert, so oft wiederholt, bis eine einstellbare Zahl von Wiederholungen erreicht ist. Danach wird automatisch über einen Adreßzähler und eine Logik ein anderes n-bit-Wort aus dem Festwertspeicher eingestellt und ebenso oft wiederholt. Die automatische Umstellung des n-bit-Worts geschieht so lange, bis alle im Festwertspeicher enthaltenen n-bit-Wörter einmal vorgekommen sind.

Da die Rahmenbitfolge dafür sorgt, daß die n-bit-Wortfolge im folgenden Zyklus um soviel bit verschoben ist, wie sich als Divisionsrest bei Division der Länge der Rahmenbitfolge durch n ergibt, wird erreicht, daß die nunmehr ausgesandte Folge von n-bit-Wörtern durch zyklische Vertauschung ihrer Bitpositionen permutiert ist. Die Länge der Rahmenbitfolge wurde teilerfremd zu n gewählt; somit ist auch der Divisionsrest teilerfremd zu n, so daß nach n Testsignalzyklen alle n durch zyklische Vertauschung möglichen Permutationen vorgekommen sind.

Die den Testsignalzyklus bestimmende Rahmenbitfolge bewirkt außerdem den Zeichensynchronismus zwischen Sender und Empfänger und synchronisiert somit auch den empfangsseitigen Wortgenerator.

Eine besonders vorteilhafte Testsignalfolge ergibt sich, wenn der Wortgenerator im Sende- und Empfangsteil eines Bitfehlermeßgerätes eingesetzt ist. In diesem Falle ist die den Testsignalzyklus auch empfangsseitig taktsynchron bestimmende Rahmenbitfolge durch die in einem r-stufigen Generator mit der Länge $2^r - 1$ erzeugte Quasizufallsfolge des Bitfehlermeßgerätes dargestellt.

Das Einblenden der periodischen Signalfolge in eine QZF hat drei Vorteile:

a) die Synchronisation des Empfängers und die Erkennung eines Synchronausfalles sind nach bekannten Methoden (z. B. DE-PS 2 359 716) während der QZF-Übertragung möglich.

b) Die Länge der QZF ist $(2^r - 1)$ bit, wenn das Generatorschieberegister r Stufen hat. Damit verschiebt sich der Anfangspunkt des folgenden periodischen Einblendmusters bezogen auf ein Raster von $2^x$ (x ganz) mit jedem QZF-Zyklus um 1 bit. Bei üblichen nach Zweierpotenzen organisierten Systemen wird damit jeder mögliche Anfangszustand erreicht. Bei anderen Rastern muß r zweckmäßig gewählt werden.

c) Eine Sende- und Empfangseinrichtung mit dem Wortgenerator nach der Erfindung deckt auch den Arbeitsbereich bekannter Bitfehlermeßgeräte ab, die nur QZF übertragen.

In einer weiteren vorteilhaften Ausgestaltung der Erfindung ist vorgesehen, daß die Periodenlänge n durch Schalter variiert werden kann. Der Festwertspeicher für die Wortinhalte ist in diesem Fall in Adreßbereiche unterteilt, die jeweils die laut Tabelle 3 notwendigen z n-bit-Wörter enthalten. Über die Schalter und eine Adreßkodierung wird die Beginnadresse des ausgewählten Speicherbereiches im Festwertspeicher am Adreßzähler eingestellt. Dieser adressiert im Festwertspeicher nacheinander die z n-bit-Wörter zur gewählten Periodenlänge n. Am Ende des Bereiches ist für jedes n das Dauerwort 1111 ... eingeschrieben. Dieses Wort ist nach den oben angestellten Überlegungen das einzige Wort, dessen letzte Ziffer eine «1» ist. Dies wird als Signal zur Rückschaltung auf die QZF verwendet. Wenn die Wortlänge n einen Teiler p hat, so daß n = p·q ist, so sind alle periodischen Signale der Wortlängen p und q selbstverständlich auch periodisch mit der Wortlänge n. So hat z. B. n = 6 Teiler p = 2 und q = 3. Tabelle 4 zeigt, daß die 4 möglichen Signale bei n = 3 in den Signalen Nr. 1, 6, 12 und 14 in der Spalte für n = 6 enthalten sind; ebenso sind die 3 Signale bei n = 2 in den Signalen Nr. 1, 10 und 14 in der Spalte für n = 6 enthalten. Werden z. B. die Wortlängen 16, 15, 14, 13, 12, 11, 10 und 9 eingestellt, so sind alle periodischen Signale kleinerer Wortlänge bereits mit erfaßt, weil die Zahlen von 2 bis 8 sämtlich Faktoren der Zahlen von 9 bis 16 sind.

Zu einer weiteren Ausgestaltung der Erfindung führt folgende Überlegung: Falls bei Bitfehlermessungen die Übertragungseinrichtung (das Meßobjekt) bei bestimmten periodischen Signalen systematische Fehler zeigt, ist es wichtig festzustellen, welche Signale das sind, damit geprüft werden kann, ob sie auch im praktischen Betrieb auftreten bzw. wie das fehlerhafte Verhalten beseitigt werden kann. Bei vollständiger Aufzeichnung der Fehlerstruktur mit Markierung des Signalzyklusbeginns z. B. durch eine künstliche Bitfehlerfolge (DE-OS 2 643 836) kann unmittelbar abgelesen werden, welche periodischen Signale wiederholt zu Bitfehlern führen. Fehlerstrukturmeßgeräte sind jedoch, insbesondere für hohe Übertragungsgeschwindigkeiten, häufig nicht verfügbar.

Der Empfänger eines mit dem Wortgenerator nach der Erfindung ausgestatteten Bitfehlermeßgerätes wird vorzugsweise dadurch ausgestaltet, daß er einen zusätzlichen Schreib-/Lesespeicher erhält, in den bei jedem Bitfehler innerhalb des periodischen Teils des Signalzyklus der gerade vorliegende Periodeninhalt aus dem Wortgenerator eingeschrieben wird. Dieser z. B. als FIFO-Speicher (first in first out) ausgelegte Speicher der kritischen Wörter enthält dann bei einer Speichertiefe t die ersten t Signalperioden, während denen Bitfehler aufgetreten sind. Ist ein kritisches periodisches Signal und der passende Anfangszustand des Systems erreicht, so treten auch die Bitfehler annähernd periodisch auf, es entsteht ein Fehlerbündel. Im FIFO-Speicher ist dann das zugehörige n-bit-Wort sehr häufig zu finden. Fehlerbündel anderen Ursprungs, die innerhalb der Aktivitätszeit des Wortgenerators auftreten, führen selbstverständlich ebenfalls zu einer mehrfachen Einspeicherung des gerade vorliegenden Worts. Das nächste Fehlerbündel dieser Art tritt dann aber mit großer Wahrscheinlichkeit nicht an derselben Stelle des Signalzyklus' auf, und es wird daher ein anderes n-bit-Wort mehrfach abgespeichert. Ein wiederholt mehrfach hintereinander auftretendes n-bit-Wort im FIFO-Speicher ist ein Zeichen für eine systematische Störung durch das zugehörige periodische Signal.

Der zusätzliche Schreib-/Lesespeicher kann genauso benutzt werden, wenn das Ansprechen der Muster-Erkennungsschaltung eines Meßobjekts festgestellt werden soll. Es ist dann nur erforderlich, statt des Bitfehlersignales das Ansprechsignal dieser Erkennungsschaltung als Schreibbefehl für den Schreib-/Lesespeicher zu verwenden. Bei korrekter Funktion der Schaltung darf dann im Schreib-/Lesespeicher nur vielfach dasjenige n-bit-Wort stehen, das für die Muster-Erkennung definiert wurde.

Ein Ausführungsbeispiel der Erfindung wird im folgenden anhand von Fig. 1 bis 5 näher erläutert.

Es zeigen:

Fig. 1 den Wortgenerator nach der Erfindung im Prinzip,

Fig. 2 den sendeseitigen Einsatz des Wortgenerators im Bitfehlermeßgerät als Blockschaltbild,

Fig. 3 den empfangsseitigen Einsatz des Wortgenerators im Bitfehlermeßgerät als Blockschaltbild,

Fig. 4 den Wortgenerator nach der Erfindung mit umschaltbarer Wortlänge n im Prinzip, und

Fig. 5 eine Tabelle zur Erläuterung der Zählweise des Wortlängenzählers.

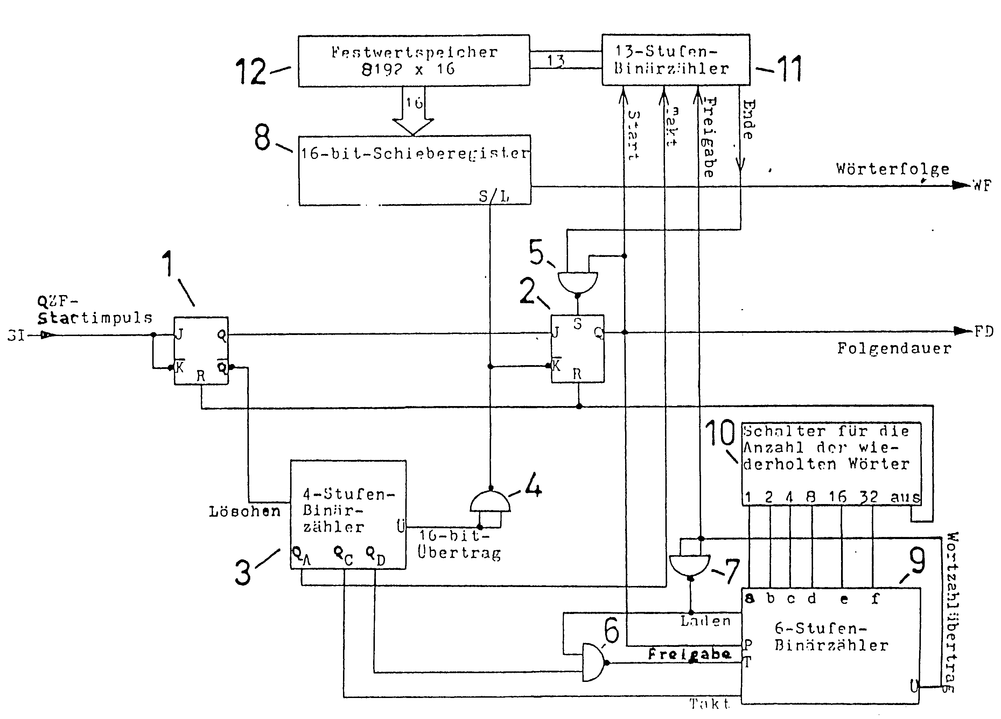

Der in Fig. 1 dargestellte Wortgenerator dient dazu, bit-synchron mit dem High-Bit des Zyklus-Startimpulses am Eingangskanal SI beginnend eine Folge von 16 bit langen Wörtern zu erzeugen und am Ausgangskanal WF abzugeben. Während der Dauer der Wörterfolge wird außerdem ein Folgendauerimpuls am Ausgangskanal FD abgegeben, der für die Umsteuerung von QZF-Messung auf Wortmessung benötigt wird. Der Taktsynchronismus wird durch die Übernahme des QZF-Taktes zur hier nicht dargestellten Steuerung der Flipflops und des Ausgangsschieberegisters gewahrt. Realisiert wird die Schaltung in dem schnellen, mit QZF-Takt betriebenen Teil mit handelsüblichen integrierten Schottky-TTL-Bausteinen, die eine maximale Schaltgeschwindigkeit von über 50 Mbit/s haben, so daß ein damit ausgestattetes Gerät für Bitraten bis zur PCM-Hierarchiestufe 34,368 Mbit/s einsetzbar ist. Verwendet werden im einzelnen

– ein Baustein 74F109, der zwei Flipflops 1, 2 mit je einem Eingang J und einem invertierenden Eingang $\overline{K}$, je einem Ausgang Q und dem das inverse Signal abgebenden Ausgang $\overline{Q}$ sowie je einem Setzeingang S und einem Rücksetzeingang R enthält.

– ein Baustein 74S163, der einen synchronen 4-Stufen-Binärzähler 3 enthält, dessen Lösch-Eingang, 16er-Übertragungsausgang Ü sowie Ausgang $Q_A$ der ersten, Ausgang $Q_C$ der dritten und Ausgang $Q_D$ der vierten Zählstufe in der Darstellung benutzt werden,

– ein Baustein 74S00, der vier Nand-Gatter 4, 5, 6, 7 enthält, und

– vier Bausteine 74S195, die je ein parallel ladbares 4-bit-Schieberegister enthalten, die über je einen S/L-Steuereingang taktsynchron zwischen Schieben und Laden umgeschaltet werden können und die in der Darstellung zu einem 16-bit-Schieberegister 8 zusammengeschaltet sind.

Die übrigen Bauelemente werden mit untersetztem QZF-Takt betrieben, und daher sind handelsübliche langsamere und dafür stromsparende Bauelemente eingesetzt, und zwar

– zwei Low-Power-Schottky-TTL-Bausteine 74LS161, die je einen parallel ladbaren 4-Stufen-Binärzähler enthalten, aus denen der dargestellte 6-Stufen-Binärzähler 9 aufgebaut ist, der über die notwendigen Freigabe-, Lade- und Takt-Eingänge verfügt und einen Übertragungsausgang Ü hat,

– einen Schalterbaustein 10 für die Einstellung des Ladesignals für den Zähler 9 einschließlich eines Ausschaltsignals für die Wortfolge,

– vier Bausteine 74LS161, aus denen der dargestellte 13-Stufen-Binärzähler 11 aufgebaut ist, und

– zwei EPROM-Speicherbausteine 2764, die je einen 8192×8 bit großen programmierbaren Festwertspeicher enthalten, aus denen der dargestellte Festwertspeicher 12 mit 16 Ausgängen aufgebaut ist.

In der dargestellten Schaltung wird der vom Eingangskanal SI als High-Bit eintreffende QZF-Startimpuls an die miteinander verbundenen Eingänge J und $\overline{K}$ des Flipflops 1 geführt, das wie ein D-Flipflop schaltet und mit der positiven Taktflanke den Startimpuls als High-Bit an den Ausgang Q und als Low-Bit an den Ausgang $\overline{Q}$ weitergibt. Das High-Bit des Startimpulses gelangt zum Eingang J des Flipflops 2 und bewirkt, daß dessen Ausgang Q auf High schaltet. Das Low-Bit des Startimpulses gelangt zum Lösch-Eingang des 4-Stufen-Binärzählers 3, der dadurch 1 bit lang von Zählen auf synchronisches Löschen umgeschaltet wird und somit passend zum Beginn der Aktivierung des Flipflops 2 auf null gesetzt wird. Danach gibt Zähler 3 an seinem Übertragsausgang Ü nach jeweils 16 bit ein High-Bit ab, das am Gatter 4 invertiert wird. Der invertierte 16-bit-Übertrasimpuls ist an den S/L-Steuereingang des Schieberegisters 8 und an den $\overline{K}$-Eingang des Flipflops 2 geführt. Am Schieberegister 8 wird jeweils ein Parallel-Laden-Vorgang für ein 16-bit-Wort ausgelöst und am Flipflop 2 das Ende des 16-bit-Worts fortlaufend markiert und damit die bitgerechte Rückschaltung des Flipflops 2 vorbereitet. Ein sofortiges Rückschalten des Flipflops 2 wird durch ein Low-Signal am Setzeingang 2 verhindert. Dieses Low-Signal kommt vom Ausgang des Gatters 5 und wird von den High-Signalen an dessen beiden Eingängen bewirkt. Ein High-Signal kommt vom Ausgang Q des Flipflops 2, das damit seine eigene Rückschaltung verhindert, das andere High-Signal ist ein Kennzeichen, das erst am Ende der Wörterfolge kurzzeitig invertiert wird und dann die Rückschaltung des Flipflops 2 ermöglicht. Der Ausgang Q des Flipflops 2 ist außerdem mit dem Freigabe-P-Eingang des 6-Stufen-Binärzählers 9 verbunden, der mit der Wortzahl m geladen ist, die angibt, wie oft jedes einzelne 16-bit-Wort erzeugt werden soll, und der mit High-Signal für den Zählbetrieb freigegeben wird. Eine weitere Voraussetzung für den Zählbetrieb ist, daß das Ladesignal inaktiv, d. h. High ist. Schließlich muß auch der Signalzustand am Freigabe-T-Eingang High sein, damit Zähler 9 zählen kann. Dieser High-Zustand ergibt sich immer dann, wenn am achtwertigen Ausgang $Q_D$ des Zählers 3, der bitweise die Wortlänge abzählt, ein Low-Signal vorliegt, das vom Ausgang $Q_D$ an den zweiten Eingang des Gatters 6 gelangt und den Gatterausgang auf High schaltet. Als Taktquelle für den Zähler 9 dient das vom Ausgang $Q_C$ des Zählers 3 ankommende Signal. Da Zähler 9 mit der positiven Taktflanke schaltet, ergeben sich die für den vierwertigen Ausgang $Q_C$ des Zählers 3 bedeutsamen Signalzustände bei den Zählwertübergängen von 3 nach 4 und von 11 nach 12.

Wegen der Bedingung, daß am achtwertigen Ausgang $Q_D$ Low-Signal vorliegen muß, bleibt als einziger Zählzeitpunkt im 16-bit-Wort der Zählwertübergang von 3 nach 4. Der 6-Stufen-Binärzähler 9 zählt nun bei diesem Zählwertübergang wortweise so lange aufwärts, bis seine Endstellung – alle Zählstufen auf High – erreicht ist. Dann schaltet der Übertragungsausgang Ü, der während des Zählens Low-Signal hatte, auf High um. Dieses High-Signal wird mit Hilfe des Gatters 7 invertiert. Das invertierte Übertragungssignal wird dem Lade-Eingang des Zählers 9 und gleichzeitig dem ersten Eingang des Gatters 6 zugeführt, wo es dafür sorgt, daß das High-Signal am Gatterausgang erhalten bleibt, wenn das vom Ausgang $Q_D$ des Zählers 3 ankommende Signal bei dessen Zählstellungen 8 bis 15 High wird. Dies hat den Zweck, daß das Übertragungssignal des Zählers 9 angeschaltet bleibt, bis der Ladevorgang abgeschlossen ist. Das ist der Fall bei der positiven Taktflanke, die vom Zählwertübergang von 11 nach 12 am Zähler 3 ausgelöst wird. Beim Ladevorgang wird das Komplement einer 6stelligen Binärzahl in den Zähler 9 geladen, die durch entsprechende Voreinstellung des Schalterbausteins 10 gegeben ist. Die größte voreinstellbare Zahl ist m = 63, entsprechend 63 Wörtern der gleichen 16-bit-Kombination, so daß jede einzelne 16-bit-Kombination ein Dauersignal von maximal 63 × 16–1008 bit ergeben kann. Am Ende jedes 16-bit-Wort-Dauersignals gibt wie beschrieben der Ausgang Ü des Zählers 9 einen High-Impuls ab, der in der Darstellung als Wortzahlübertragung bezeichnet und dem 13-Stufen-Binärzähler 11 als Freigabe-Impuls zugeführt wird. Der Zähler 11 dient dazu, an seinen 13 Binärausgängen die Auswahladressen der z = 4116 Werte (siehe Tabelle 3) im Festwertspeicher 12 zu erzeugen. Das adressierte 16-bit-Wort wird über 16 Ausgänge an die Parallel-Lade-Eingänge des Schieberegisters 8 abgegeben. Das Schieberegister wird über den S/L-Eingang so gesteuert, daß es 1 bit lang lädt und 15 bit lang schiebt, so daß an seinem Ausgang die gewünschte Folge unterschiedlicher Dauersignale entsteht, die jeweils aus einer Reihe gleichartiger 16-bit-Wörter gebildet sind. Diese Wörterfolge wird vom Schieberegister 8 an den Ausgangskanal WF abgegeben. Wenn durch fortgesetzte Freigabe durch den vom Zähler 9 kommenden Wortzahlübertrag der 13-Stufen-Binärzähler 11 alle seine 4116 Wortadressen durchlaufen hat, gibt er das Ende-Kennzeichen als Low-Signal an das Gatter 5 ab, dessen Ausgang auf High und damit den Setzeingang S des Flipflops 2 inaktiv schaltet. Das Flipflop 2 wird beim nächsten Low-Signal am Eingang $\overline{K}$ rückgeschaltet, d. h. das High-Signal, das während der Wörterfolge am Ausgang Q lag und als Folgedauersignal an den Ausgangskanal FD abgegeben wurde, geht zurück auf Low. Da der Zähler 3 auch in der Wörterfolgenpause im Zählerbetrieb bleibt, bleibt auch das an seinem Ausgang $Q_A$ abgegebene Taktsignal für den Zähler 11 erhalten, so daß dieser während der Wörterfolgenpause auf seinen Anfangswert geladen und für das nächste vom Flipflop 2 kommende Startsignal vorbereitet wird.

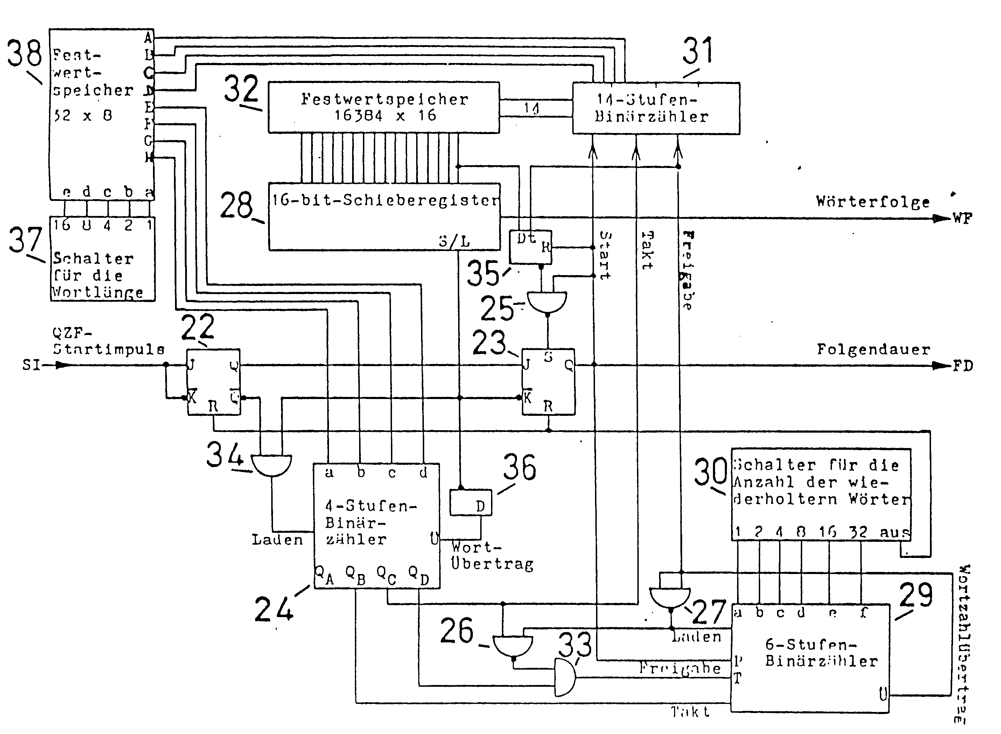

Fig. 2 zeigt den sendeseitigen Einsatz des Wortgenerators im Bitfehlermeßgerät und enthält den QZF-Generator 13, den bereits beschriebenen Wortgenerator 14 und einem Umschalter 15, der das Sendesignal an den Ausgangskanal des Bitfehlermeßsenders abgibt. Der QZF-Generator 13 erzeugt die Quasizufallsfolge, die durch passende Rückkopplung eines r-stufigen Schieberegisters so erzeugt wird, daß die Folge eine maximale Zykluslänge von $(2^r-1)$ bit hat, ehe sie sich wiederholt. Der Beginn der Wörterfolge wird sende- und empfangsseitig durch den Startimpuls SI festgelegt, der aus der Dekodierung eines der $(2^r-1)$ verschiedenen Schaltzustände des Schieberegisters gewonnen wird. Die Einblendung der Wörterfolge WF in die Quasizufallsfolge QZF geschieht am Umschalter 15 während des Highzustandes des Folgendauersignals FD. Dabei sind zwei Betriebsweisen möglich; der QZF-Generator kann während der Wörterfolge weiterlaufen, d. h. ein Teil der QZF wird durch die Wörterfolge ersetzt, oder er kann angehalten werden. In der abgebildeten ersten Betriebsweise wird ein Teil der QZF durch die Wörterfolge ersetzt, was voraussetzt, daß der QZF-Zyklus länger ist als die Folgendauer. Die längste Folgendauer des dargestellten Wortgenerators ist 16 · 63 · 4116 = 4148928 bit; daraus folgt bei voller Ausnutzung der möglichen Folgendauer, daß das Schieberegister des QZF-Generators 13 mindestens r = 22 Stufen haben muß, was eine Zykluslänge von $2^{22}-1$ = 4194303 bit bedeutet. Da eine vom CCITT empfohlene Stufenzahl r = 23 mit der QZF-Zykluslänge 8388607 bit ist, käme diese QZF für das vorgeschlagene Bitfehlermeßgerät in Frage. Bei der nicht dargestellten zweiten Betriebsweise wird der QZF-Generator während der Wörterfolge angehalten, so daß auch Stufenzahlen r < 22 gewählt werden können; es muß aber beim Verlust des Zeichensynchronismus auf der Empfangsseite dafür gesorgt werden, daß der neu zu synchronisierende Vergleichs-QZF-Generator solange ständig läuft, bis der Empfänger wieder synchron zum Sender arbeitet.

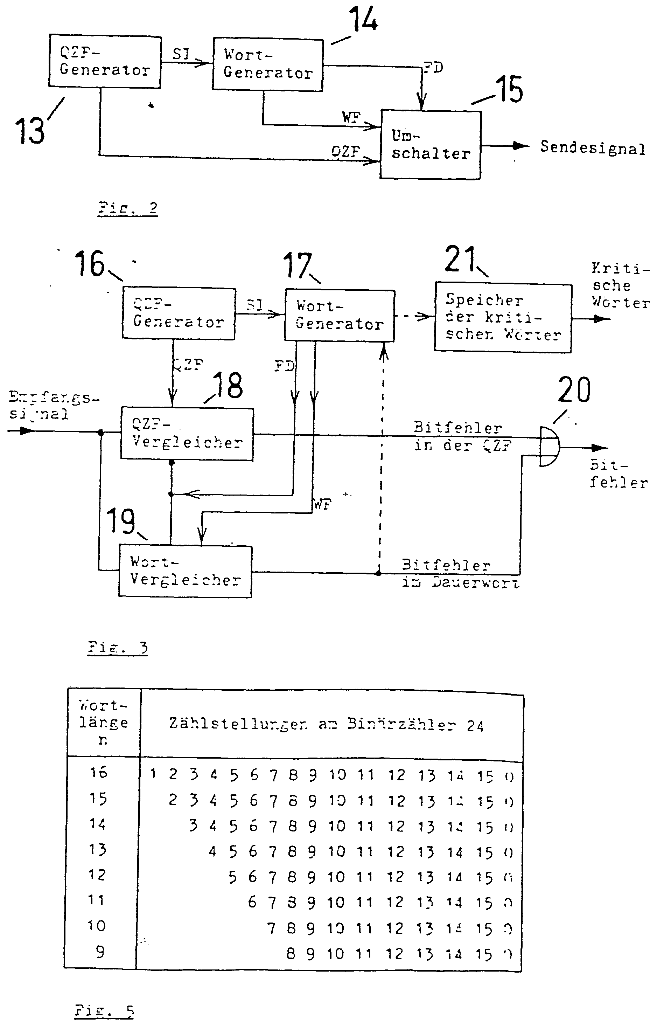

Fig. 3 zeigt den empfangsseitigen Einsatz des Wortgenerators im Bitfehlermeßgerät und enthält einen QZF-Generator 16, den eingangs beschriebenen Wortgenerator 17, einen QZF-Vergleicher 18, einen Wort-Vergleicher 19 und ein Summenglied 20 sowie einen Speicher der kritischen Wörter 21. Der QZF-Generator 16 entspricht weitgehend dem von der Sendeseite bekannten QZF-Generator 13 und wird mit dem von der Sendeseite kommenden Meßsignal synchronisiert. Er erzeugt das Vergleichssignal QZF im Empfänger sowie den Startimpuls SI, der angibt, wann die sendeseitig eingeblendete Wörterfolge beginnt. Der Wortgenerator 17 erzeugt dann die Vergleichs-Wörterfolge WF und während der Wörterfolge das Folgendauersignal FD, das den beiden Vergleichern 18 und 19 zugeführt wird und je nach Schaltzustand einen der beiden aktiviert. Beide Vergleicher nehmen auch das vom Eingangskanal kommende Empfangssignal auf. Der QZF-Vergleicher 18 vergleicht beim Low-Zustand des Signals FD die Quasizufallsfolge QZF des Vergleichsgenerators 16 mit den QZF-Anteilen des Empfangssignals und legt bei Abweichungen bitweise High-Signal an seinen Ausgang «Bitfehler in der QZF», der mit dem ersten Eingang des Summierglieds 20 verbunden ist. Entsprechend vergleicht der Wort-Vergleicher 19 beim High-Zustand des Signals FD die Wortfolge WF des Wortgenerators 17 mit den Wort-Anteilen des Empfangssignals und legt bei Abweichungen bitweise High-Signal an seinen Ausgang «Bitfehler im Dauerwort», der mit dem zweiten Eingang des Summierglieds 20 verbunden ist. Im inaktiven Vergleicherzustand sind die Ausgänge beider Vergleicher jeweils abwechselnd im Schaltzustand Low. Das Summierglied 20 ist als Oder-Gatter dargestellt, das an seinem Ausgang High-Signal abgibt, wenn mindestens einer der beiden Eingänge High-Signal hat; demzufolge werden die mit High gekennzeichneten Bitfehler in der QZF und im Dauerwort addiert und ergeben am Ausgang des Summierglieds 20 eine Bitfolge, die bei fehlerfreiem Betrieb Low-Signal und im Fehlerfall bitweise High-Signal hat. Diese Bitfolge wird als Fehlersignal an den Ausgangskanal Bitfehler abgegeben. Im Blockschaltbild ist die Ansteuerung des Speichers der kritischen Wörter 21 gestrichelt dargestellt, was diesen Speicher als Zusatzeinrichtung kennzeichnen soll. Da beim Erkennen eines Bitfehlers im Dauerwort der Wortgenerator 17 im Empfänger gerade auf der Auswahladresse des fehlerempfindlichen, d. h. eines kritischen Wortes steht, ist die Übernahme dieses Wortes in einen Speicher leicht möglich. Als Speicher wird ein Schreib-/Lese-Speicher vorgeschlagen, der als FIFO-Speicher organisiert ist, die kritischen Wörter schnell aufnehmen kann und nach Zwischenspeicherung an den Ausgabebus «Kritische Wörter» zur Aufzeichnung abgibt.

Der in Fig. 4 dargestellte Wortgenerator mit umschaltbarer Wortlänge n, der auf n = 9, 10, 11, 12, 13, 14, 15 oder 16 bit eingestellt werden kann, ist nach dem gleichen Prinzip aufgebaut wie der eingangs beschriebene 16-bit-Wortgenerator. Bitsynchron mit dem High-Bit des QZF-Startimpulses am Eingangskanal SI beginnend wird eine Folge von n bit langen Wörtern erzeugt und dem Ausgangskanal WF zugeführt. Während der Dauer der Wörterfolge wird auch hier ein Folgendauerimpuls am Ausgangskanal FD abgegeben. Wie beim 16-bit-Wortgenerator werden verwendet

– ein Baustein 74F109, der zwei Flipflops (22, 23) enthält,

– ein Baustein 74S163, der einen 4-Stufen-Binärzähler (24) enthält,

– ein Baustein 74S00, der vier Nand-Gatter enthält, von denen drei (25, 26, 27) benutzt werden,

– vier Bausteine 74S195, die zu einem 16-Bit-Schieberegister (28) zusammengeschaltet sind,

– zwei Bausteine 74LS161, die zu einem 6-Stufen-Binärzähler (29) zusammengeschaltet sind,

– ein Schalterbaustein (30) zur Einstellung des Ladesignals für den Zähler 29 einschließlich eines Ausschaltsignals für die Wortfolge und

– vier Bausteine 74LS161, die zu einem 14-Stufen-Binärzähler (31) zusammengeschaltet sind.

Die beiden EPROM-Speicherbausteine des 16-bit-Wortgenerators werden durch solche eines anderen Typs ersetzt, und zwar durch:

– zwei EPROM-Speicherbausteine 27128, die je einen 16384×8 bit großen programmierbaren Festwertspeicher enthalten, aus denen der dargestellte Festwertspeicher 32 mit 16 Ausgängen aufgebaut ist.

Zusätzlich benötigt werden

– ein Baustein 74S08, der vier And-Gatter enthält, von denen zwei 33, 34 benutzt werden,

– ein Baustein 74S74, der zwei D-Flipflops 35, 36 mit herausgeführten Ausgängen Q und den invertierten Ausgängen $\overline{Q}$ enthält, von denen eines 36 mit dem QZF-Takt betrieben wird,

– ein Schalterbaustein 37 für die Eingabe der gewünschten Wortlänge und

– ein PROM-Speicherbaustein 74188, der einen 32×8 bit großen programmierbaren Festwertspeicher 38 enthält, mit dem die eingestellte Wortlänge in Ladesignale für die Binärzähler 24 und 31 umgewertet werden.

In der Schaltung mit umschaltbarer Wortlänge darf der 4-Stufen-Binärzähler 24 nicht freilaufend betrieben werden, sondern muß bei jedem Wortübertrag auf einen Anfangswert geladen werden, der von der eingestellten Wortlänge abhängt und mit dem erreicht wird, daß der Wortübertragsabstand gleich der Wortlänge ist. Geladen wird der Zähler 24, wenn Low-Signal an seinem Lade-Eingang liegt. Das Low-Signal kann einerseits vom QZF-Startimpuls herrühren, der vom Flipflop 22 aufgenommen und als Low-Impuls an dessen Ausgang $\overline{Q}$ abgegeben wird, oder vom Wortübertrags-High-Impuls, der vom D-Flipflop 36 datentaktgebunden invertiert wird. Diese beiden Signalquellen sind an die Eingänge des And-Gatters 34 geführt und zwingen den Ausgang auf Low-Signal, wenn einer der Gattereingänge Low-Signal empfängt, und aktivieren dann den Lade-Eingang des Zählers 24, der daraufhin den an seinen vier Eingängen a, b, c und d anliegenden binären Zählwert bei der positiven Taktflanke an seine Zählausgänge $Q_A$, $Q_B$, $Q_C$ und $Q_D$ weiterschaltet. Beim 16-bit-Wort-Betrieb ist der Ladezählwert 0001, und nicht null wie im Schaltungsbeispiel der Fig. 1, weil durch den Austausch des den Wortübertragsimpuls invertierenden Nand-Gatters gegen das invertierende Flipflop 36 ein bit Verzögerung entsteht, die notwendig ist, um eine Kettenschaltung von Gattern und eine Summierung von Signallaufzeiten zu vermeiden, die die maximale Bitrate der Schaltung herabsetzen würde. Der Lade-Zählwert ist höher, wenn eine Wortlänge von weniger als 16 bit eingestellt wird. Der größte Ladewert ergibt sich bei den 9-bit-Wörtern und beträgt 8 (d. h. binär 1000). Die Lade-Zählwerte für die übrigen Wortlängen sind aus der Tabelle der Fig. 5 zu entnehmen. Aus dieser Tabelle ist auch ersichtlich, daß die Zählstellungen 8 (1000), 9 (1001), 10 (1010), 11 (1011), 12 (1100), 13 (1101), 14 (1110), 15 (1111) und 0 (0000) bei allen Wortlängen vorkommen; diese Zählstellungen können deshalb für die Takt- bzw. Freigabe-Steuerung der Zähler 29 und 31 verwendet werden. Der Zähler 29 wird zum Zählen freigegeben, wenn am Zähler 24 die Zählstellungen 8, 9, 10 oder 11 erreicht sind; dann sind der Ausgang $Q_C$, der an den ersten Eingang des And-Gatters 33 geführt ist, im High-Zustand und der Ausgang $Q_D$, der an den ersten Eingang des Nand-Gatters 26 geführt ist, im Low-Zustand; der Ausgang des Nand-Gatters 26 wird unabhängig vom Schaltzustand des anderen Eingangs auf High gezwungen, das an den zweiten Eingang des And-Gatters 33 gelangt und von dessen Ausgang nach der Und-Verknüpfung als High-Signal an den Freigabe-T-Eingang des Zählers 29 weitergegeben wird. Geschaltet wird der Zähler 29 mit der positiven Flanke des Taktsignals, das vom Ausgang $Q_B$ des Zählers 24 kommt, der die positive Signalflanke beim Übergang von Zählstellung 1 nach 2, 5 nach 6, 9 nach 10 und 13 nach 14 erzeugt; hier von Bedeutung ist demnach der Übergang von 9 nach 10, bei dem der Zähler 29 um eine Zählstellung erhöht wird. Wenn Zähler 29 dadurch seine Übertragsstellung (= Wortzahlübertrag) erreicht, also den Ausgang Ü auf High-Signal schaltet, muß der Freigabe-T-Eingang so lange auf High gehalten werden, bis der Lade-Vorgang abgeschlossen ist; das geschieht mit dem Low-Signal des vom Nand-Gatter 27 invertierten Wortzahlübertrags, das an den zweiten Eingang des Nand-Gatters 26 geführt ist und dessen Ausgang unabhängig vom Signalzustand am ersten Eingang auf High hält. Mit der nächsten positiven Taktflanke wird Zähler 29 dann geladen; das geschieht dann beim Zählwertübergang von 13 nach 14 am Zähler 24. Der Wortzahlübertrag ist also während der Zählstellungen 10, 11, 12 und 13 aktiv; bei diesen Stellungen ist demnach der Adreßzähler 31 freigegeben, der vom Ausgang $Q_C$ des Zählers 24 mit Takt versorgt wird und bei dessen Zählwertübergang von 11 nach 12 (positive Flanke) weiterschaltet. Der Zähler 31 ist 14stufig, weil er die Adressen für den Festwertspeicher 32 bereitstellen muß, der doppelt so groß ist wie beim 16-bit-Wortgenerator, weil er die Testwörter für alle vorgesehenen Wortlängen n enthalten muß. Aus der Tabelle 3 geht hervor, wie viele unterschiedliche Testwörter für jedes n von 9 bis 16 gespeichert werden müssen. Um den Festwertspeicher 32 auf einfache Weise adressieren zu können, beginnen die Bereiche der einzelnen Wortlängen n bei vollen Kbit-Adressen (1 Kbit = 1024 bit), die als Startadresse für die jeweilige Wortlänge n während der Wörterfolgenpause in den 14-Stufen-Binärzähler 31 geladen werden. Wie aus der Tabelle 3 hervorgeht, reichen für die Wortlängen n = 9, 10, 11, 12 und 13 je ein Kbit-Bereich aus; für n = 14 werden zwei, für n = 15 drei und für n = 16 fünf Kbit-Bereiche benötigt; das ergibt 15 der zur Verfügung stehenden 16 Bereiche. Die Testwörter werden «rechtsbündig» in das 16-bit-Schieberegister 28 eingeschrieben. Da das Steuersignal am Eingang S/L des Schieberegisters 28 der invertierte Wortübertrag ist, wird das Schieberegister abwechselnd 1 bit lang geladen und (n−1) bit lang geschoben, so daß die Wörterfolge mit der eingestellten Wortlänge n automatisch richtig am Ausgang des Schieberegisters entsteht. Das Wörterfolgen-Ende muß bei umschaltbarer Wortlänge anders markiert werden als beim 16-bit-Wortgenerator; im Festwertspeicher 32 ist das letzte Testwort für alle Wortlängen n der Zustand «alle n bit auf High»; somit geht das n-te Bit des Testworts, das bei allen anderen Testwörtern Low-Signal hat, auf High. Der Speicherausgang des n-ten Bits ist mit dem D-Eingang des Flipflops 35 verbunden; dieses Flipflop hat als Takt den Wortzahlübertragsimpuls, der am Ende der Wörterfolge den Ausgang $\overline{Q}$ des Flipflops 35 auf Low schaltet und somit das Ende-Kennzeichen bewirkt. Das Flipflop 35 wird in der Wörterfolgenpause vom Ausgang Q des Flipflops 23 asynchron zurückgesetzt.

**Patentansprüche**

1. Digitaler Wortgenerator zur automatischen Erzeugung periodischer Dauerzeichen aus n-bit-Wörtern aller Wortgewichte und deren Permutationen, dadurch gekennzeichnet, daß von den $2^n$ möglichen Wortgewichten und Permutationen eines n-bit-Worts während eines Testsignalzyklus' nur n-bit-Wörter einer wesentlich kleineren Anzahl z nacheinander aus einem Festwertspeicher (12) abgerufen werden und die übrigen $(2^n-z)$ Permutationen dadurch entstehen, daß sich an den periodischen Teil eine den Testsignalzyklus bestimmende Rahmenbitfolge anschließt, deren Länge mit n keinen gemeinsamen Teiler hat, so daß in n Testsignalzyklen nacheinander alle n möglichen zyklischen Vertauschungen der Binärstellen der im Festwertspeicher (12) vorliegenden Wörter erzeugt werden.

2. Digitaler Wortgenerator nach Anspruch 1, dadurch gekennzeichnet, daß während eines Testsignalzyklus' jedes aus dem Festwertspeicher (12) ausgelesene n-bit-Wort, über einen Schalter (10) und einen Binärzähler (9) gesteuert, so oft wiederholt wird, bis eine einstellbare Zahl von Wiederholungen erreicht ist, daß danach automatisch über einen Adreßzähler (11) und eine Logik (4 bis 7) ein anderes n-bit-Wort aus dem Festwertspeicher eingestellt und ebenso oft wiederholt wird und daß die automatische Umstellung des n-bit-Worts so lange geschieht, bis alle im Festwertspeicher enthaltenen n-bit-Wörter einmal vorgekommen sind.

3. Digitaler Wortgenerator nach Anspruch 1 und 2, dadurch gekennzeichnet, daß er im Sende- und Empfangsteil eines Bitfehlermeßgeräts eingesetzt ist und daß die den Testsignalzyklus und den Zeichensynchronismus bestimmende Rahmenbitfolge durch die in einem r-stufigen Generator (13, 16) erzeugte Quasizufallsfolge der Länge $(2^r-1)$ des Bitfehlermeßgerätes dargestellt ist, in welche an festgelegter Musterstelle die vom Wortgenerator (14) erzeugte Folge von n-bit-Wörtern über einen Umschalter (15) eingeblendet wird.

4. Digitaler Wortgenerator nach Anspruch 1, 2 und 3, dadurch gekennzeichnet, daß empfangsseitig mit einem zusätzlichen Schreib-/Lese-Speicher (21) diejenigen kritischen n-bit-Wörter aufgezeichnet werden, bei deren fortlaufender Übertragung Bitfehler entstehen, und dem Bitfehlerausgabeprotokoll als Zusatzinformation beigefügt werden.

5. Digitaler Wortgenerator nach Anspruch 1, 2 und 3, dadurch gekennzeichnet, daß die Wortlänge n der n-bit-Wörter in den sende- und empfangsseitigen Festwertspeichern (32, 38) auf alle Werte von n = 9 bis 16 bit einstellbar ist, so daß mit den als Teiler enthaltenen Wortlängen n = 1 bis 8 bit alle mit Wörtern der Länge n = 1 bis 16 bit erzeugbaren Dauerfolgen übertragbar sind.

**Claims**

1. Digital word generator for automatically generating periodic permanent signals from n bit words of all weights and their permutations, characterised in that, of the $2^n$ possible word weights and permutations of an n bit word during a test signal cycle, only n bit words of a substantially smaller number z are recalled in succession from a permanent memory (12), and the remaining ($2^n$–z) permutations are produced when a frame bit sequence, which determines the test signal cycle, is added to the periodic part, the length of said frame bit sequence having no common submultiple with n, with the result that all n possible, cyclic commutations of the binary positions of the words present in the permanent memory (12) are generated in n test signal cycles in succession.

2. Digital word generator according to claim 1, characterised in that, during a test signal cycle, each n bit word, which is selected from the permanent memory (12) and controlled via the intermediary of a switch (10) and a binary counter (9), is repeated until a settable number of repetitions is attained, then another n bit word from the permanent memory is selected automatically, via the intermediary of an address counter (11) and a logic arrangement (4 to 7), and is repeated as often, and the automatic transposition of the n bit word is effected for so long until all the n bit words contained in the permanent memory have in fact appeared.

3. Digital word generator according to claims 1 and 2, characterised in that it is inserted in the transmitting and receiving part of a bit fault measuring apparatus, and in that the frame bit sequence, which determines the test signal cycle and the synchronism of the signals, is represented by the quasi random sequence of the length ($2^r$–1) of the bit fault measuring apparatus, which quasi random sequence is produced in an r-stepped generator (13, 16) and into which quasi random sequence the sequence of n bit words generated by the word generator (14) is gated at a fixed location in the pattern via the intermediary of a changeover switch (15).

4. Digital word generator according to claims 1, 2 and 3, characterised in that those critical n bit words, which cause bit faults to be produced during their continuous transmission, are indicated at the receiving end with an additional read-write memory (21) and are added to the bit fault output protocol as additional information.

5. Digital word generator according to claims 1, 2 and 3, characterised in that the word length n of the n bit words in the permanent memories (32, 38) at the transmitting and receiving ends can be set to all the values from n = 9 bit to n = 16 bit, so that all the permanent sequences, which can be generated with words of the length n = 1 bit to n = 16, can be transmitted with the word lengths n = 1 bit to n = 8 bit contained as submultiples.

**Revendications**

1. Générateur numérique de mots pour la production automatique de signaux permanents périodiques constitués de mots à n bits de tous poids et leurs permutations, caractérisé en ce que parmi les $2^n$ poids possibles de mots et les $2^n$ permutations d'un mot à n bits, pendant un cycle du signal de test, seuls des mots à n bits d'un nombre nettement plus petit z de permutations sont appelés successivement à partir d'une mémoire morte (12) et les autres ($2^n$–z) permutations sont obtenues grâce au fait qu'à la partie périodique se raccorde une séquence de bits de trame, qui détermine le cycle du signal de test et dont la longueur n'a aucun diviseur commun avec n, de sorte qu'au cours de n cycles du signal de test, les n changements cycliques possibles des positions binaires des mots présents dans la mémoire morte (12) sont tous produites successivement.

2. Générateur numérique de mots selon la revendication 1, caractérisé en ce que, pendant un cycle du signal de test, chaque mot à n bits lu dans la mémoire morte (12) est répété, sous la commande d'un interrupteur (10) et d'un compteur binaire (9), jusqu'à ce qu'un nombre réglable de répétitions soit atteint, en ce qu'ensuite, un autre mot à n bits est automatiquement réglé à partir de la mémoire morte et répété aussi souvent, par l'intermédiaire d'un compteur d'adresses (11) et d'une unité logique (4 à 7), et en ce que le décodage automatique du mot à n bits est exécuté jusqu'à ce que tous les mots à n bits contenus dans la mémoire morte soient apparus une fois.

3. Générateur numérique de mots selon les revendications 1 et 2, caractérisé en ce qu'il est utilisé dans la partie émission et dans la partie réception d'un appareil de mesure d'erreurs sur les bits et en ce que la séquence de bits de trame, qui détermine le cycle du signal de test et le synchronisme des signaux, est représentée par la séquence quasi-aléatoire, de longueur ($2^r$–1), de l'appareil de mesure des erreurs sur les bits, qui est produite dans un générateur (13, 16) à r étages et dans laquelle la séquence de mots à n bits, produite par le générateur de mots (14), est insérée au moyen d'un commutateur (15) en un emplacement type fixé.

4. Générateur numérique de mots selon les revendications, 1, 2 et 3, caractérisé en ce que, sur le côté réception, les mots critiques à n bits, lors de la transmission en continu desquels il apparaît des erreurs sur les bits, sont enregistrés dans une mémoire supplémentaire d'enregistrement/lecture (21) et sont adjoints, en tant qu'information supplémentaire, au protocole de sortie des erreurs sur les bits.

5. Générateur numérique de mots selon les revendications 1, 2 et 3, caractérisé en ce que la longueur de mot n des mots à n bits est réglable, dans les mémoires mortes (32, 38) situées sur le côté émission et sur le côté réception, sur toutes les valeurs allant de n = 9 à n = 16 bits, de sorte qu'avec les longueurs de mot n = 1 à n = 8 bits, stockées en tant que diviseurs, il est possible de transmettre toutes les séquences permanentes produites avec des mots ayant une longueur de n = 1 à n = 16 bits.

EP 0201634 B1

38 Festwertspeicher 32 x 8

37 Schalter für die Wortlänge

A B C D E F G H
e d c b a
16 8 4 2 1

32 Festwertspeicher 16384 x 16

28 16-bit-Schieberegister

S/L

31 14-Stufen-Binärzähler

14

35 Dt R

25

Start Takt Freigabe

Wörterfolge WF

QZF-Startimpuls

SI

22 J Q / K R Q̄

34 Laden

24 4-Stufen-Binär-zähler
a b c d
Q_A Q_B Q_C Q_D

36 D

U Wort-Übertrag

23 J S Q / K R

Folgendauer FD

30 Schalter für die Anzahl der wiederholtern Wörter
1 2 4 8 16 32 aus

26

33

27 Laden

29 6-Stufen-Binärzähler
a b c d e f
T
U

Freigabe

Takt

Wortzahlübertrag

Fig. 2

Fig. 3

| Wort-länge n | Zählstellungen am Binärzähler 24 | | | | | | | | | | | | | | | |
|---|---|---|---|---|---|---|---|---|---|---|---|---|---|---|---|---|
| 16 | 1 | 2 | 3 | 4 | 5 | 6 | 7 | 8 | 9 | 10 | 11 | 12 | 13 | 14 | 15 | 0 |
| 15 | | 2 | 3 | 4 | 5 | 6 | 7 | 8 | 9 | 10 | 11 | 12 | 13 | 14 | 15 | 0 |
| 14 | | | 3 | 4 | 5 | 6 | 7 | 8 | 9 | 10 | 11 | 12 | 13 | 14 | 15 | 0 |
| 13 | | | | 4 | 5 | 6 | 7 | 8 | 9 | 10 | 11 | 12 | 13 | 14 | 15 | 0 |
| 12 | | | | | 5 | 6 | 7 | 8 | 9 | 10 | 11 | 12 | 13 | 14 | 15 | 0 |
| 11 | | | | | | 6 | 7 | 8 | 9 | 10 | 11 | 12 | 13 | 14 | 15 | 0 |
| 10 | | | | | | | 7 | 8 | 9 | 10 | 11 | 12 | 13 | 14 | 15 | 0 |
| 9 | | | | | | | | 8 | 9 | 10 | 11 | 12 | 13 | 14 | 15 | 0 |

Fig. 5

15